Europäisches Patentamt

European Patent Office

Office européen des brevets

(11) Publication number: **0 231 740**
**A2**

# EUROPEAN PATENT APPLICATION

(21) Application number: 87100011.3

(51) Int. Cl.4: **H01L 29/72**

(22) Date of filing: 02.01.87

(30) Priority: 30.01.86 US 824388

(43) Date of publication of application:
**12.08.87 Bulletin 87/33**

(84) Designated Contracting States:
**DE FR GB IT**

(71) Applicant: **TEXAS INSTRUMENTS
INCORPORATED
13500 North Central Expressway
Dallas Texas 75265(US)**

(72) Inventor: **Verret, Douglas P.
13807 Bay Tree Drive Douglas
Sugar Land Texas 77478(US)**
Inventor: **Brighton, Jeffrey E.
3233 Windchase Apartment 1121
Houston Texas 77082(US)**
Inventor: **Hollingsworth, Deems Randy
1611 Turtle Creek
Missouri City Texas 77459(US)**
Inventor: **Torreno, Manuel Luis, Jr.
12207 Meadow Lake Drive
Harris Texas 77077(US)**

(74) Representative: **Leiser, Gottfried, Dipl.-Ing. et
al
Patentanwälte Prinz, Leiser, Bunke & Partner
Manzingerweg 7
D-8000 München 60(DE)**

(54) A polysilicon self-aligned bipolar device and process of manufacturing same.

(57) A bipolar transistor formed on the face of a semiconductor substrate which includes an extrinsic base of a first conductivity type formed in a portion of an emitter-base region of said semiconductor. A conducting base contacting layer is formed over the extrinsic base which has a non-conducting spacer formed over a sidewall thereof. An intrinsic base in the emitter-base region is juxtaposed to the extrinsic base. An emitter of a second conductivity type is formed within the intrinsic base with an edge of the emitter being aligned with an outer edge of the spacer.

FIG. 1

# A POLYSILICON SELF-ALIGNED BIPOLAR DEVICE AND PROCESS OF MANUFACTURING SAME

## RELATED APPLICATIONS

The present application is a continuation-in-part of Application Serial No. 824,388 filed January 30, 1986.

## BACKGROUND

The present invention relates to a method of fabrication of a compact high-speed bipolar device in VLSI technology.

The semiconductor industry has sought methods of fabrication to improve the switching speed and reduce the size of bipolar devices. One technique developed in pursuit of this objective is a polysilicon self aligned device. In 1978 Nippon Electric Company of Japan developed a self aligned bipolar device which utilized a local oxide separation method to separate the base region and the N+ emitter published in October, 1978 in "IEEE Journal of Solid State Circuits, Vol. SC-13, No. 5, pp. 693-698 by K. Okada". Oxide Isolation was also used to separate the emitter from the collector. Due to the size constraints of such oxide, the Okada device does not lend itself to significant size reduction.

Fairchild Camera and Instrument as described in U. S. Patent No. 4,148,468 issued December 6, 1983 by M. Vora used the basic concept of the polysilicon aligned device, except it deposited the N+ polysilicon initially and then grew a thin spacer oxide after which the P+ was deposited. In growing the spacer oxide the base is oxidized making control of the base profile difficult. Further a high temperature oxidation is done to drive the impurities and grow oxide on the P+ polysilicon. Since the oxidation is performed at 1,000 °C. It is difficult to keep the base profile shallow using the Vora method. Moreover, oxidation of the P+ results in boron segregation out of the polysilicon into the oxide thus causing a depletion of boron concentration at the polysilicon surface. As with the Okada approach Vora separates the collector from the emitter by isolation oxide.

U. S. Patent No. 4,481,706 issued November 13, 1984 to M. Roche describes a polysilicon self-aligned device in which the spacer oxide was deposited rather than grown. However, the emitter is formed by an implant and subsequent diffusion of the emitter prior to deposition of polysilicon. Such a method of application makes it difficult to make the junctions very shallow. Furthermore, the base of Roche requires a substantial anneal due to the lateral diffusion required to meet the P+ contact region. In addition, a nitride layer is used in the spacer file thereby complicating the process.

U. S. Patent No. 4,431,460 issued February 14 to Barson et al. following on with the Roche method omitted the nitride from the spacer film. However, the lateral uses the same oxide film for the P+ polysilicon cap as well as for the spacer. Using the same conformal film makes it extremely difficult to optimally reduce the base resistance, emitter-base capacitance and at the same time maintain a sufficiently high emitter-base breakdown voltage.

Siemens AG published a paper entitled "Self-Aligned Bipolar Technology-New Chances for Very High Speed Digital Integrated Circuits by A. Wieder, Siemens Forsch. und Entw. Berichte Bd. 13, 1984, pp. 246-252" which appears to use the same film for the P+ polysilicon cap and the spacer plug. Thus, the latter device would therefore have the same disadvantages as discussed with respect to U. S. Patent No. 4,431,460.

Accordingly, it is an object of the invention to provide an improved bipolar semiconductor device. It is a further object of the invention to provide an improved bipolar device which exhibits high speed and small dimensions. It is yet another object of the present invention to provide a bipolar semiconductor device which has a significantly smaller emitter to base spacing.

## SUMMARY OF THE INVENTION

According to the invention there is provided a bipolar transistor formed on the face of a semiconductor substrate which includes an extrinsic base of a first conductivity type formed in a portion of an emitter-base region of said semiconductor. A conducting base contacting layer is formed over the extrinsic base which has a non-conducting spacer formed over a sidewall thereof. An intrinsic base in the emitter-base region is juxtaposed to the extrinsic base. An emitter of a second conductivity type is formed within the intrinsic base with an edge of the emitter being aligned with an outer edge of the spacer.

Preferably, the transistor includes a buried collector of a second conductivity type, local oxide isolation strips on the face defining the emitter-base region and a separate collector contact area adjacent to the emitter-base region and a trench isolating the transistor from adjacent cells on the semiconductor substrate.

BRIEF DESCRIPTION OF THE DRAWINGS

The novel features believed characteristic of the invention are set forth in the appended claims. The invention itself, however, as well as other features and advantages thereof, will be best understood by reference to the detailed description which follows, read in conjunction with the accompanying drawings, wherein:

Figures I to 27 are greatly enlarge sectional elevation views of one cell of a semiconductor chip made in accordance with a preferred embodiment of the invention and showing the device at successive stages of manufacture;

Figures 28 and 29 are an alternative planarization method of preparing the contacts for metallization;

Figure 30 is a plan view of a resistor fabricated in a separate cell; and

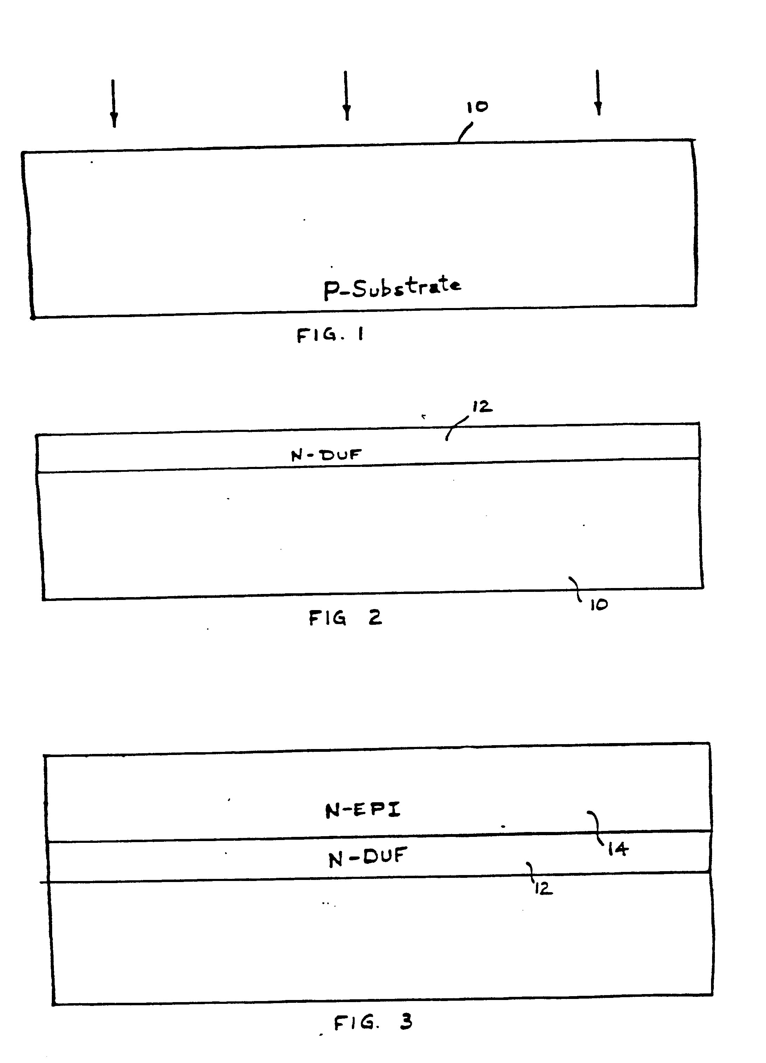

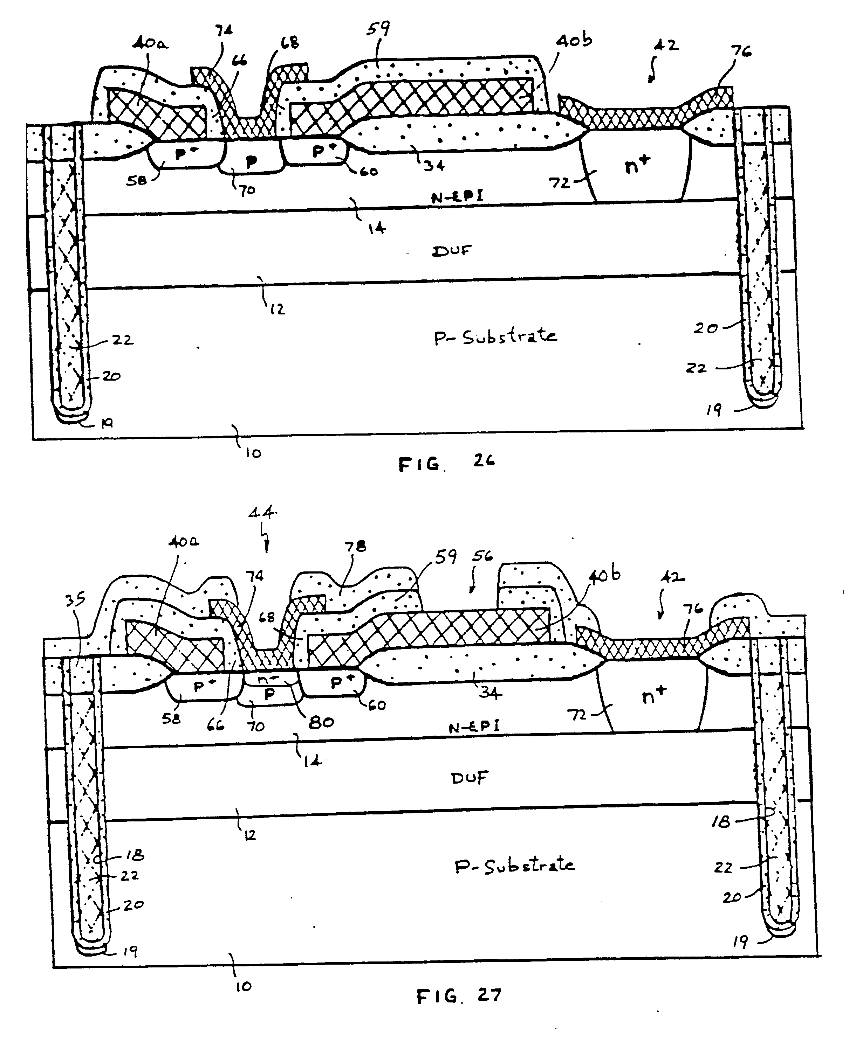

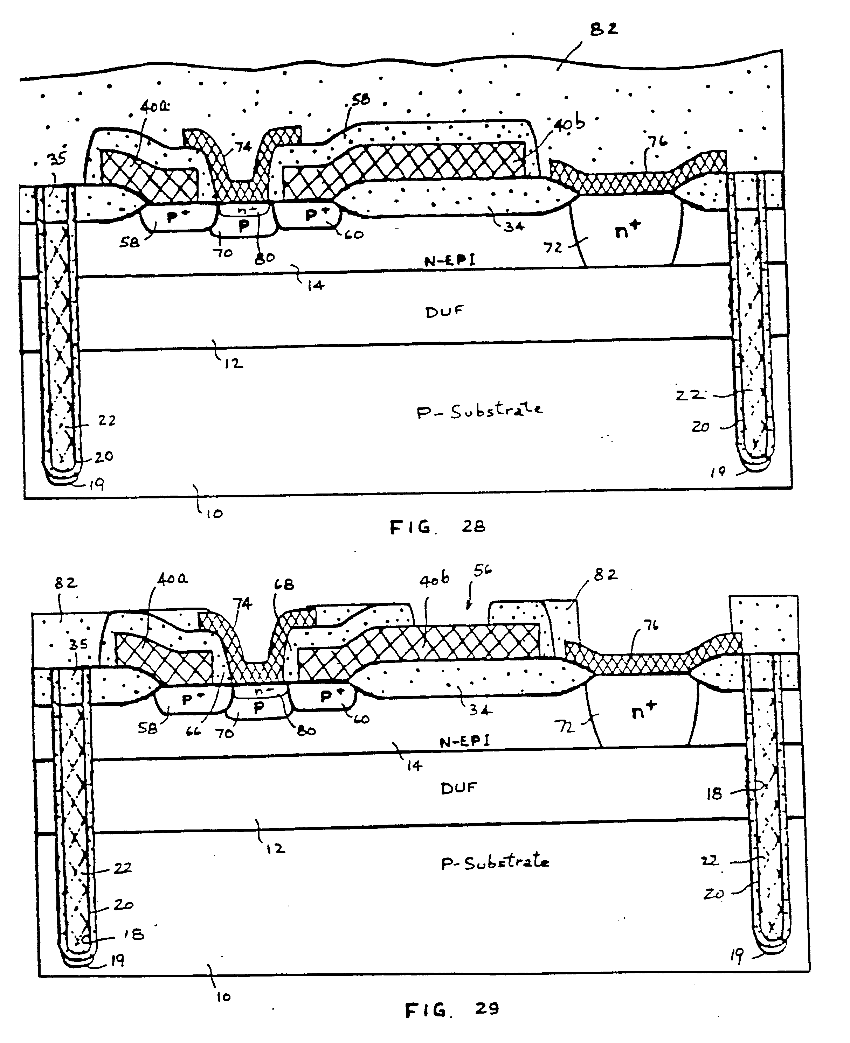

Figure 3I is a plan view of the structure of Figures 27 and 29 after metal has been deposited.

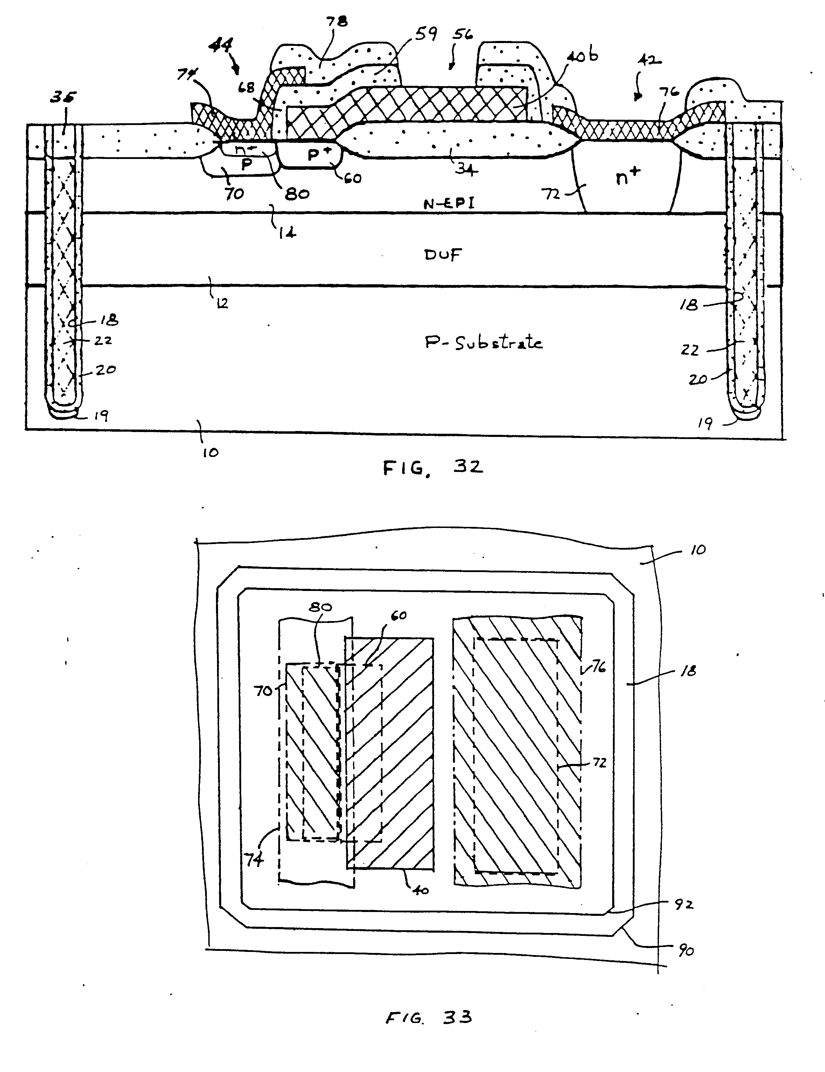

Figure 32 is an enlarged sectional elevation view of one cell of an alternative embodiment of the invention in which the extrinsic base and contact thereto is on one side as opposed to the four sides shown in Figures 28 and 29.

Figure 33 is a top or plan view of the structure of Fig. 32.

DETAILED DESCRIPTION WITH REFERENCE TO THE DRAWINGS

Referring to Figure 27 there is shown a bipolar transistor cell formed in a P-conductivity type semiconductor substrate I0. The cell is one of many formed on a silicon wafer (not shown) which, in turn, is divided up into a number of chips. Each chip also contains a number of such cells. Each transistor consists of a monocrystalline P-type silicon substrate I0 having an N-type antimony implanted DUF region I2 extending a thickness of 3 to 3.5 microns into the wafer. An N-type epitaxial layer I4 is deposited over the DUF region I2 to a thickness of I.0 to I.4 microns. Polysilicon filled trenches I8 each about I.5 to 2 microns wide and 8 microns deep divide up the substrate I0 and epitaxial layer I4 into a number of regions in which bipolar transistor cells are formed. The sidewalls of each trench I8 are lined with a thin oxide layer 20 and filled with polysilicon 22. A channel stop region I9 is formed at the bottom of each trench I8. The

use of a thin oxide layer coupled with polysilicon avoids stress fractures in the silicon and oxide that would otherwise occur with a thick oxide isolation layer.

The active area of each transistor cell is formed between a pair of isolation trenches I8 by local oxide isolation the spaces between which define an emitter-base region 44 and a collector contact region 42 (see also Fig. 3I). The local oxide isolation areas 34 are grown to approximately 4,000 to 5,000 Angstroms in thickness. During the latter oxidation the top 35 of the polysilicon 22 in each trench I8 is converted to oxide as well. An $N^+$-type conductivity region 72 is formed in the epitaxial layer I4 extending from the DUF region I2 up to the surface of the collector contact area 42. An N-type conductivity polysilicon layer 76 forms the collector contact to region 72.

In the emitter-base region 44 there are developed a pair of spaced apart $P^+$-type regions 58 and 60 formed along each side of region 44 to a depth from the surface of about I,500 to 5,000 Angstroms. Between the latter regions there is implanted and diffused a P-type conductivity region 70 and then an $N^+$-type conductivity emitter region 80 formed by diffusion from doped polysilicon in the top portion of region 70 to a depth of about 500 to 2,000 Angstroms. Contact to each $P^+$-type region 58 and 60 is provided by $P^+$-type doped amorphous silicon regions 40a and 40b, respectively. A low pressure chemical vapor deposited oxide layer 59 of 3,000 to 5,000 Angstroms thickness covers the regions 40a and 40b and includes sidewall spacers 66 and 68 which space the emitter region 80 from the inactive base regions below regions 40a and 40b, respectively. An $N^+$-conductivity type polysilicon layer overlies the emitter 80 between sidewall spacers 66 and 68 to form the emitter contact. A layer of phosphosilicate glass (PSG) 78 is deposited over the oxide 59 and etched to open to emitter contact layer 74, a base contact layer 56 and collector contact layer 76. Metal contacts and interconnects are then deposited and etched (not shown).

Referring to Figures I and 2, there is shown a P-type silicon substrate I0 being subjected to a blanket implant of a donar species to a post anneal depth of 3 to 3.5 microns and a final sheet resistance of I0 -20 ohms per square. Using antimony as the implanted donor species rather than impurities such as arsenic or phosphorous results in relatively little up diffusion into the overlying epitaxial layer since antimony diffuses much more slowly in silicon than do other types of donor impurities. Consequently, antimony is a preferred dopant species. Next as seen in Figure 3 an N-type epitaxial layer I4 is deposited over the antimony implanted DUF region I2 at reduced pressure to a thickness

of 1.0 to 1.4 microns with resistivity 0.3 to 1.0 ohm-cm. This thickness of epitaxial layer 14 is about 20% less than the thicknesses of epitaxial layers used in conventional technologies and requires shallow emitter and base regions.

A layer of silicon dioxide 16 is then deposited to a thickness of about 1.0 to 1.5 microns. A layer of photoresist (not shown) is then deposited over the silicon dioxide exposed to ultra violet light through a mask and the exposed portions removed in order to expose trench regions. Depending on the number of cells there may be several such trench regions. The trench region 18 is then etched to form a deep trench extending below the DUF region 12 having a width of 1.5 to 2.0 microns by etching the exposed silicon dioxide. The photoresist is then removed and the silicon is then etched using the silicon dioxide as an etch mask.

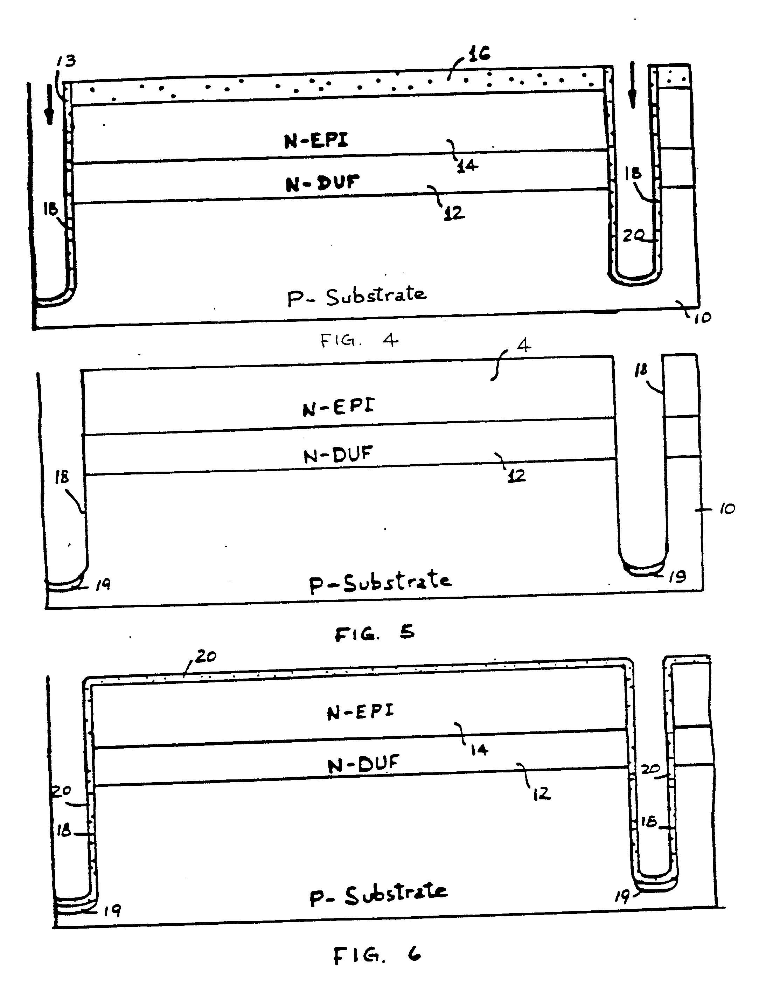

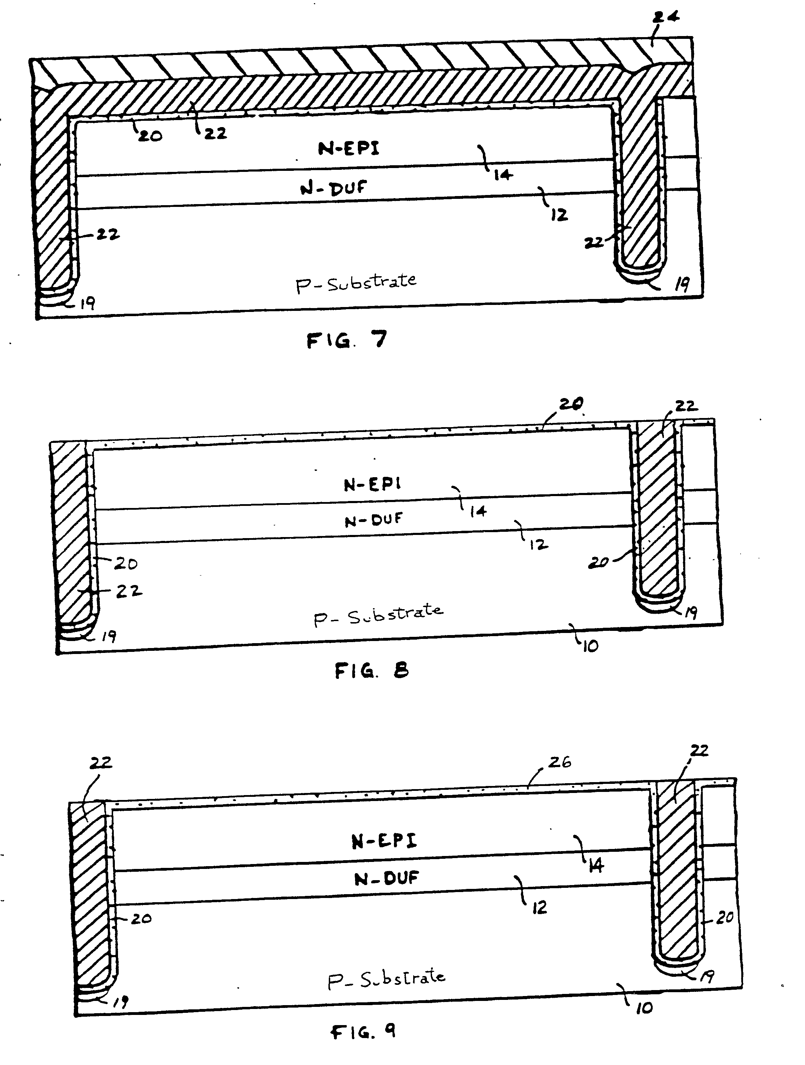

As shown in Figure 4, a sidewall oxide 13 is grown over the walls of the trenches 18 by placing the cell in an atmosphere of steam at a temperature of approximately 1,000 °C for about 15 minutes. A channel stop boron implant is then directed into the trench 18 at an energy of 40 to 60 keV and a concentration of about $1 \times 10^{14}$ atoms per square centimeter to form a P+ channel stop region 19 below each trench 18 in order to prevent an inversion layer from forming around the trench oxide sidewall 13. An etch removes the layer of silicon dioxide 16 on the surface of the N-epitaxial layer 14 and on the trench sidewalls as shown in Figure 5. A new layer of sidewall oxide is grown as shown in Figure 6.

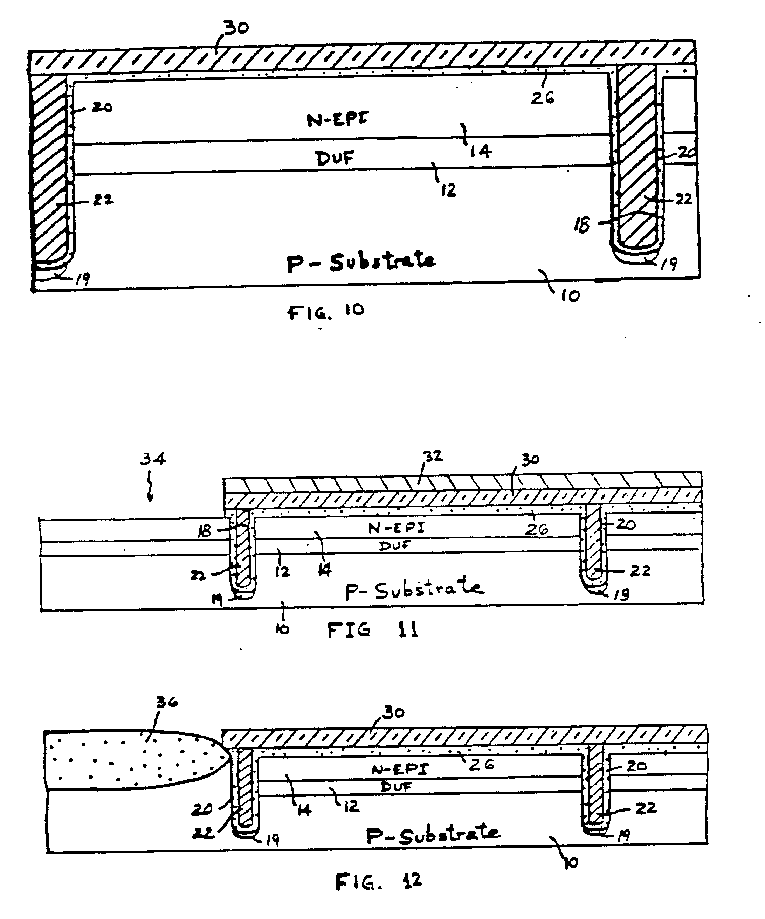

Next the trench 18 are filled with a polysilicon deposit 22 as seen in Figure 7 and onto the latter layer is deposited a layer of photoresist 24 which is flat. An etch is selected to have an etch rate which will etch the photoresist 24 at substantially the same rate as the underlying polysilicon. Thus, upon etching the photoresist and polysilicon down to the silicon surface a flat oxide surface as seen in Figure 8 is achieved. By using the active device area present in devices using ordinary oxide isolation is avoided and the packing density can be increased significantly. In oxide isolation the current design rule requires a separation of 8-10 microns between transistors whereas with a polysilicon filled trench the 1.5-2 micron width of the trench is the limit in separation.

Referring to Figure 9, the oxide layer 20 is removed with a new oxide layer 26 being grown to a thickness of 800 to 1,200 Angstroms. A layer of silicon nitride 30 is formed over the oxide surface by a low pressure chemical vapour deposition as seen in Figure 10. A layer of photoresist 32 is deposited over the nitride 30 and then patterned, and the exposed isolation region 34 etched to remove the nitride 30 and oxide 26 as seen in

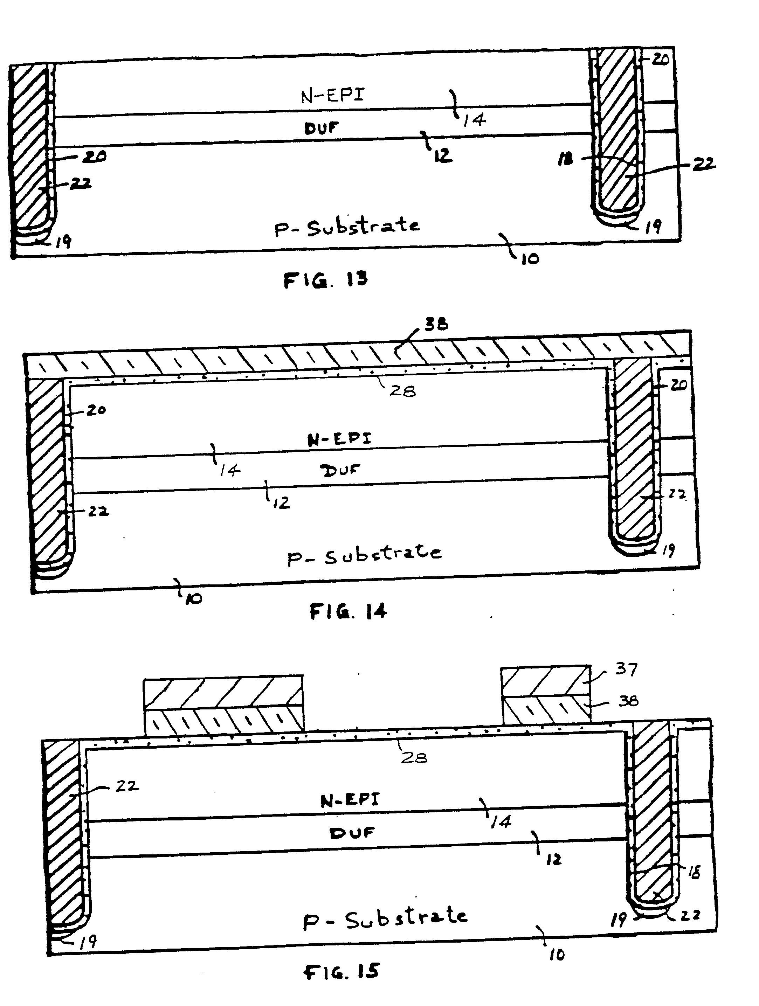

figure 11. The entire wafer is then exposed to an oxidizing high pressure atmosphere at about 900 °C for about 2 hours. During oxidation silicon is consumed so that a relatively thick oxidation isolation region 36 is formed as seen in Figure 12.

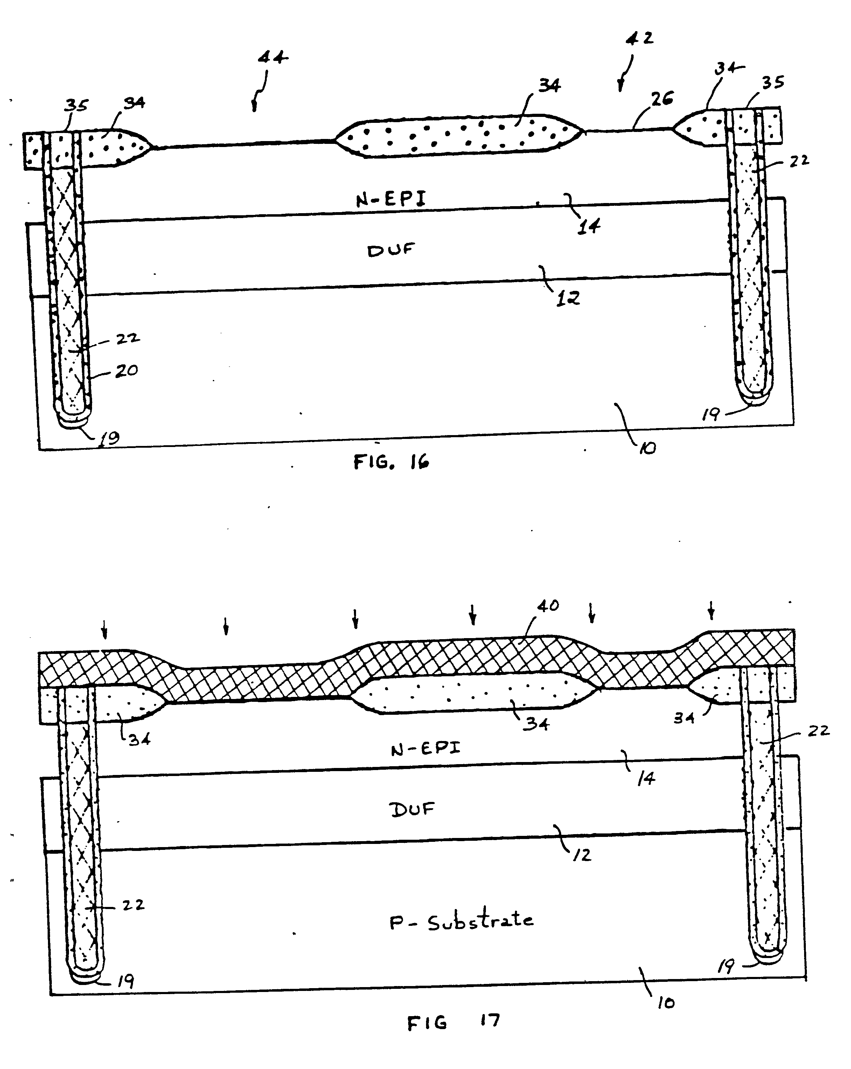

Next, as shown in Figure 13, the nitride and oxide are etched off. A new layer of oxide 28 is grown to a thickness of 300 to 500 Angstroms and a layer of nitride 38 is deposited by low pressure chemical vapor deposition over the oxide layer 28 to a thickness of 700 to 1,000 Angstroms as shown in Figure 14. A photoresist layer 37 is then deposited, patterned and developed to expose areas where local oxide isolation strips (LOCOS) are to be formed. The nitride 38 in the opened regions is etched down to oxide layer 28 as shown in Figure 15. Then oxide 34 is grown in the regions not covered by nitride by again placing the wafer in an oxidizing atmosphere at about 1,000 °C for about 2 hours to form an oxide layer of 3,000 to 5,000 Angstroms thick as shown in Figure 16. During this step polysilicon 22 at the top of the trench 18 is converted to oxide 35.

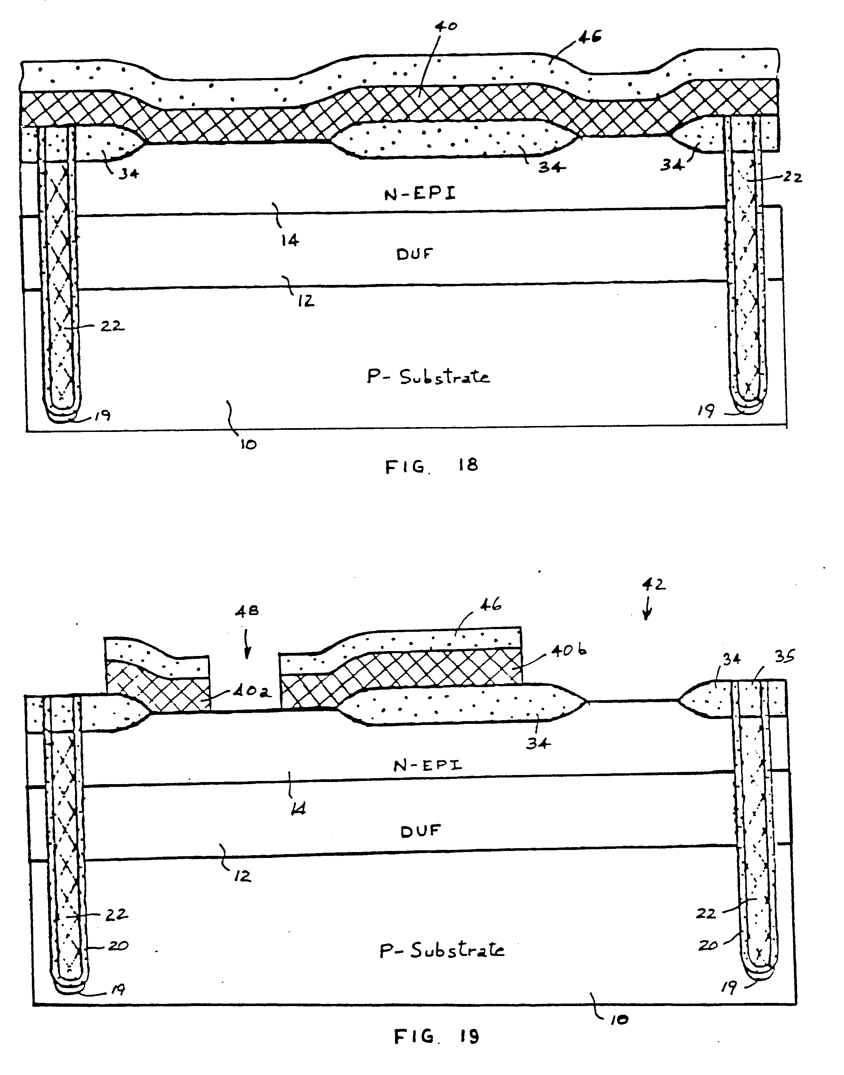

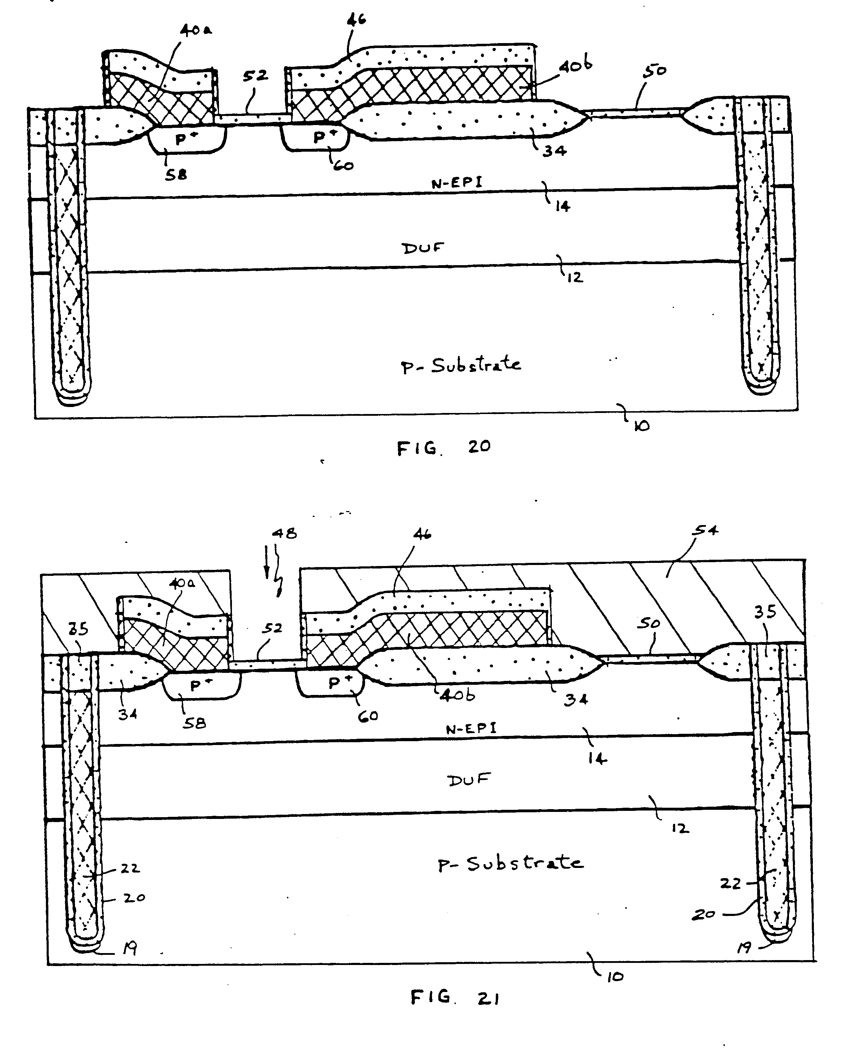

After the nitride 38 and oxide 28 layers are removed, low pressure chemical vapor deposition (LPCVD) is used to deposit a layer of amorphous silicon 40 of 3,000 to 5,000 Angstroms thickness over the entire wafer. The amorphous silicon is then doped with boron to a sheet resistance of 50 to 200 ohms/square as seen in Figure 17. Amorphous silicon 40 is used rather than polysilicon because of the better etch uniformity of the former. The amorphous silicon 40 is capped with a LPCVD oxide 3,000 to 5,000 Angstroms thick as shown in Figure 18. The amorphous silicon 40 and oxide 46 are then patterned and etched using photoresist as shown in Figure 19 to form two stacks 40a and 40b which each overlap the emitter-base region 44. The latter etch is followed by a thin oxidation growth of 800 to 1,500 Angstroms during which boron in the amorphous silicon layers 40a and 40b diffuse into the epitaxial layer 14 to form diffused base areas 58 and 60, respectively, joined at either end as shown in Fig. 31. Following oxidation thin oxide layers 52 and 50 are formed over emitter region 48 and collector contact region 42 as shown in Fig. 20.

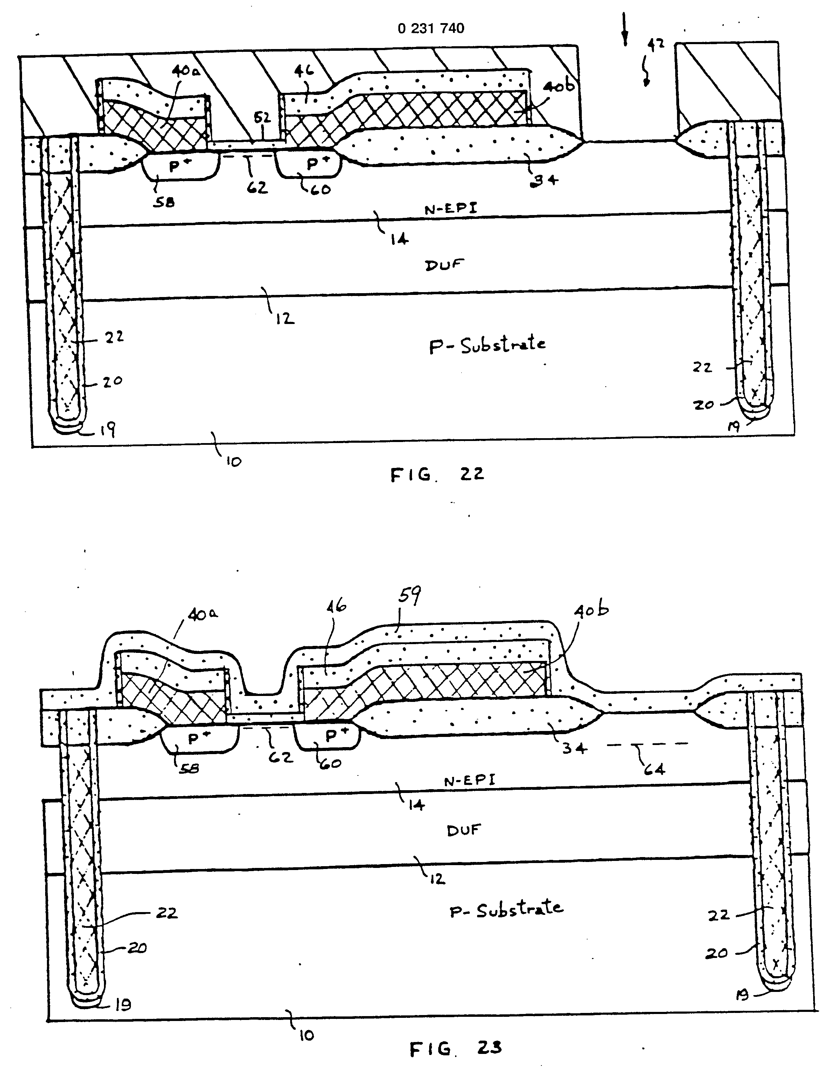

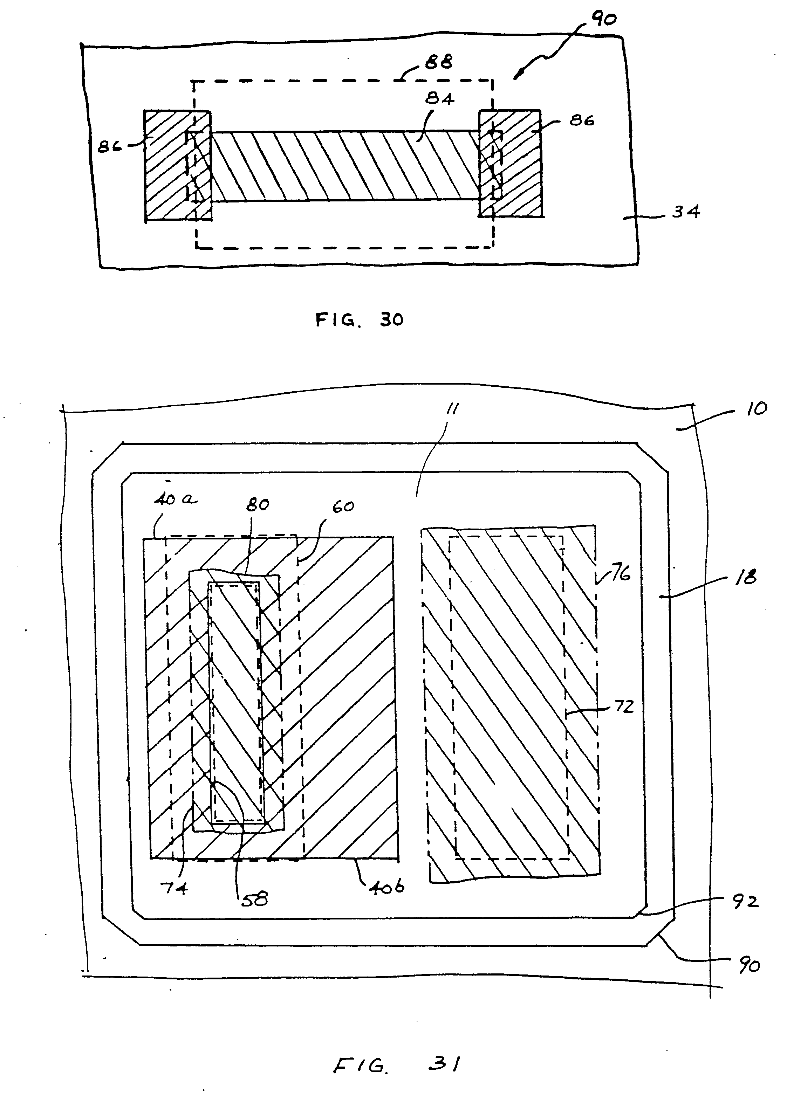

Photoresist 54 is deposited and patterned to open a region 48 corresponding to a proposed emitter and extrinsic base region and then an boron implant is made through the thin oxide 52 at an energy of 40 to 60 keV at a concentration suitable to obtain a sheet of 600 to 1,000 ohms per square. Using photoresist patterning a resistor 90 as seen in Figure 30 of high sheet resistance is also formed by implanting boron at a concentration suitable to obtain a high sheet resistance of 2,000 to 5,000 ohms per square in region 84. The low implant energy and implanting through thin oxide results in a very shallow junction. The collector contact area 42 is defined by photoresist 56 and implanted with phosphorous as seen in Figure 22. A deep phosphorous implant at an energy of 100-200 keV is effected with a concentration in the range of $4 \times 10^{15}$ to $3 \times 10^{16}$ atoms per square centimeter.

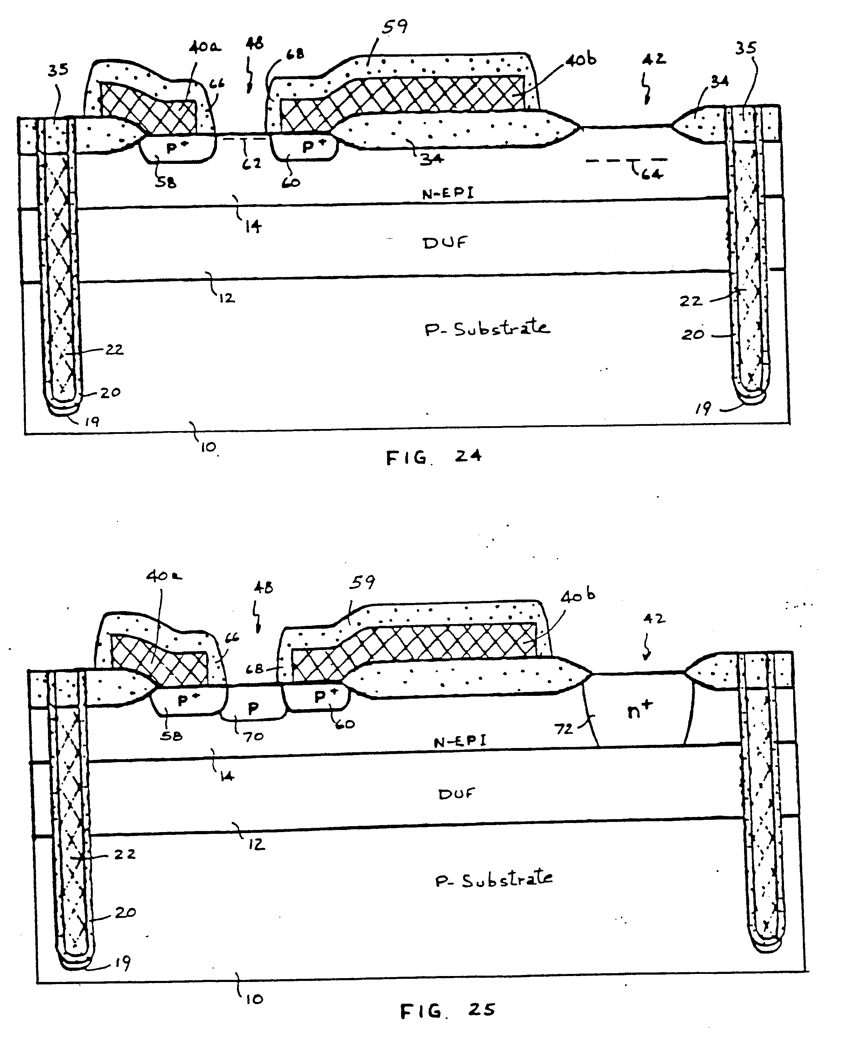

The next process step involves formation of sidewall spacers by first laying down a conformal deposition of LPCVD oxide 59 seen in Figure 23 which is then etched back with an anisotropic dry etch leaving oxide plugs 66 and 68 on the sidewalls of the oxide/amorphous silicon stacks as seen in Figure 24. Alternatively, silicon nitride or polysilicon (undoped) can be used in place of oxide 59. The plugs or spacers 66 and 68 define the spacing between the inactive portion of base regions 58 and 60 and the emitter 80 (see Figure 27). Referring to Figures 25 and 26, polysilicon is deposited in emitter opening 48 and collector opening 42. A phosphorous implant is made into the polysilicon at an energy in the range of 80 to 100 keV and at a concentration in the range of $5 \times 10^{15}$ to $2 \times 10^{16}$ atoms per square centimeter. Then the polysilicon is patterned and etched to form emitter 74 and collector 76 contacts as seen in Figure 26. A layer of phosphosilicate glass (PSG) 78 is then deposited for stabilization and all contacts including base, collector, emitter, resistor contacts and Schottky diodes (not shown) are patterned and etched as seen in Figure 27.

Alternatively, as seen in Figures 28 and 29 a thick oxide layer 82 may be deposited after formation of polysilicon contacts 74 and 76 followed by etching to produce a substantially planar top surface and then patterning and etching contacts. Conventional metallization processing is then used to provide interconnects.

A top view of the structure of Figures 27 and 29 is shown in Figure 31. In this case the trench 18 encloses a transistor region 11 on a chip 10. The trench has its sidewalls 90 and 92 at corners angled at 45° with respect to each corresponding intersecting trench sidewall to make the trench width substantially constant at the corners. This is done to avoid voids created in the polysilicon used to fill the trench at corners where no such angles exist.

The extrinsic P+-type base 58 and 60 is seen to form a rectangular ring enclosing N+-type emitter 80. Polysilicon contact 74 engages the emitter 80 while amorphous silicon contact 40a and 40b contacts the extrinsic base 58 and 60 on all four sides. Polysilicon layer 76 is shown contacting collector contact N+-type region 72.

Figures 32 and 33 show an alternative scheme in which the amorphous silicon layer 40 and associated extrinsic base 60 extend along only one side of emitter 80.

In addition to a thin epitaxial layer, high switching speed and low base resistance and inherent advantages of the polysilicon emitter, the present device achieves a relatively small collector-base capacitance due to the small inactive base area and shallow P+ junction. Also, the short spacing between the inactive portion of the base and the emitter significantly reduces the base resistance. The minimizing of the former spacing is achieved by utilizing the oxide spacers 66 and 68 to define the separation between the emitter and the inactive portion of the base. Platinum silicide is preferably used between the polysilicon and metal in order to reduce contact resistance.

While this invention has been described with reference to an illustrative embodiment, this description is not intended to be construed in a limiting sense. Various modifications of the illustrative embodiment, as well as other embodiments of the invention, will be apparent to persons skilled in the art upon reference to this description. It is, therefore, contemplated that the appended claims will cover any such modifications or embodiments as fall within the true scope of the invention.

## Claims

1. A bipolar transistor formed on the face of a semiconductor, comprising:
   an extrinsic base of a first conductivity type formed in a portion of an emitter-base region of said semiconductor;
   a conductive base contacting layer formed at least partially over said extrinsic base having a non-conducting spacer formed over a sidewall thereof over said emitter-base region;
   an intrinsic base in said emitter-base region contiguous to said extrinsic base;
   and an emitter of a second conductivity type formed within said intrinsic base having an edge adjacent to said extrinsic base and aligned with an outer edge of said spacer; and
   isolation means enclosing said transistor.

2. A transistor according to claim 1, including a buried collector of the second conductivity type extending beneath said emitter and base.

3. A transistor according to claim 2, wherein said emitter is formed by depositing an impurity doped emitter contact layer over said emitter region abutting said spacer and heating the emitter region to drive the impurity to said emitter region.

4. A transistor according to claim 3, wherein said base is formed by depositing a base contact layer doped with base impurity over a corresponding base region and heating said base contact layer to drive the base impurity therein into said base region.

5. A transistor according to claim 4, including a collector contact region for providing electrical contact to said buried collector and local oxide isolation separating the emitter-base region from said collector contact region.

6. A transistor according to claim 2, wherein said isolation means includes a trench extending down through said buried collector.

7. A transistor according to claim 6, wherein said trench encloses said transistor.

8. A transistor according to claim 7, wherein said trench is coated with a thin oxide layer and then filled with polysilicon.

9. A transistor according to claim 7, wherein said trench has a substantially constant width.

10. A transistor according to claim 7, including a channel stop region below said trench.

11. A transistor according to claim 5, wherein said collector contact region is formed by a deep implant of impurity of the second conductivity type and subsequent diffusion of the deep implant.

12. A transistor according to claim 11, wherein said emitter is N-type, said base is P-type and said collector is N-type.

13. A transistor according to claim 4, wherein said emitter and base contact layers are polysilicon.

14. A method of fabricating a bipolar transistor on a face of a semiconductor substrate which has an emitter-base region and a spaced apart collector contact area, including;

forming an extrinsic base doped conducting layer of a first conductivity type over a portion of said emitter-base region;

forming a sidewall insulating spacer on a sidewall of said extrinsic base layer;

diffusing extrinsic base impurity from said extrinsic base doped conducting layer into said semiconductor to form an extrinsic base region;

implanting and diffusing intrinsic base impurity into a remaining portion of said emitter-base region to form an intrinsic base therein contiguous with said extrinsic base;

forming an emitter impurity doped emitter contact layer of a second conductivity type over a portion of said intrinsic base region abutting said spacer; and

heating said semiconductor to form an emitter therein within said intrinsic base.

15. A method according to claim 31, including implanting and diffusing impurity of a second conductivity type into said substrate to form a collector and growing a thin epitaxial layer over said collector wherein said emitter and base regions are formed in said epitaxial layer.

16. A method according to claim 32, including implanting a collector impurity deeply into a collector contact region below said collector contact area in said epitaxial layer and subsequently diffusing the collector impurity throughout said collector contact region.

17. A method according to claim 33, including forming an isolation trench extending into said substrate and enclosing said transistor.

18. A method according to claim 34, wherein said extrinsic base contact layer is low pressure chemical vapour deposited amorphous silicon doped with an impurity of said first kind.

FIG. 1

FIG 2

FIG. 3

FIG. 4

FIG. 5

FIG. 6

**FIG. 7**

N-EPI
20  22
14
N-DUF
12
22
22
P-Substrate
19  19
24

**FIG. 8**

20  22
N-EPI
14
N-DUF
12
20
20
22
P-Substrate
19
19
10

**FIG. 9**

22  26  22
N-EPI
14
N-DUF
12
20
20
P-Substrate
19
19
10

FIG. 10

FIG 11

FIG. 12

N-EPI

DUF

P- Substrate

**FIG. 13**

N-EPI

DUF

P- Substrate

**FIG. 14**

N-EPI

DUF

P- Substrate

**FIG. 15**

N-EPI

14

DUF

12

22

20

19

10

FIG. 16

N-EPI

14

DUF

12

22

P- Substrate

19

10

FIG 17

FIG. 18

FIG. 19

0 231 740

FIG. 20

FIG. 21

0 231 740

FIG. 22

FIG. 23

FIG. 24

FIG. 25

FIG. 26

FIG. 27

FIG. 28

FIG. 29

FIG. 30

FIG. 31

FIG. 32

FIG. 33